# EUROPÄISCHE PATENTSCHRIFT

(11) **EP 2 505 049 B1**
(45) Veröffentlichungstag und Bekanntmachung des Hinweises auf die Patenterteilung: **10.01.2018**
(21) Anmeldenummer: 10776583.6
(22) Anmeldetag: 03.11.2010
(51) Int. Cl.: H05K 7/14, H05K 5/00

(54) **GEHÄUSESYSTEM**
HOUSING SYSTEM
SYSTÈME DE BOÎTIER

(30) Priorität: 25.11.2009 DE 102009054437
(43) Veröffentlichungstag der Anmeldung: 03.10.2012
(73) Patentinhaber: SEW-EURODRIVE GmbH & Co. KG, 76646 Bruchsal (DE)
(72) Erfinder: KARST, Andreas, 75239 Eisingen (DE); HUBER, Martin, 77830 Bühlertal (DE); JUNGINGER, Alexander, 75196 Remchingen-Wilferdingen (DE)
(74) Vertreter: Tüngler, Eberhard
(86) Internationale Anmeldenummer: PCT/EP2010/006686
(87) Internationale Veröffentlichungsnummer: WO 2011/063884

(56) Entgegenhaltungen:
- DE-U1- 29 713 441
- US-A- 4 597 291
- US-A1- 2005 189 889
- US-A1- 2007 140 234
- US-A1- 2009 023 320

## Beschreibung

Die Erfindung betrifft ein Gehäusesystem.

Ein Gehäusesystem ist aus der DE 10 2004 034 834 B4 bekannt.

**Aus der** US 2007/140234 A1 **ist ein Gehäuse für eine Signalübertragungsanordnung bekannt.**

**Aus der** US 2009/023320 A1 **ist ein elektrisches modulares Bussystem bekannt.**

**Aus der** US 4 597 291 A **ist ein modulares Gehäusesystem bekannt, das aus miteinander verbindbaren Teilen besteht.**

**Aus der** DE 297 13 441 U1 **ist ein Adapter zur Befestigung eines Schalttafelgehäuses an einer Hutschiene bekannt.**

**Aus der** US 2005/189889 A1 **ist ein modular aufgebautes Steuersystem für einen Wechselstrommotor bekannt.**

Der Erfindung liegt daher die Aufgabe zugrunde, ein Gehäusesystem weiterzubilden, wobei das Gehäusesystem eine hohe Variabilität aufweist.

Erfindungsgemäß wird die Aufgabe bei dem Gehäusesystem nach den in Anspruch 1 angegebenen Merkmalen gelöst.

Wichtige Merkmale der Erfindung bei dem Gehäusesystem sind, dass das Gehäusesystem vorzugsweise für eine elektronische und/oder elektrische Vorrichtung vorgesehen ist und mindestens zwei Gehäuseteile mit je einem zugehörigen Gehäusedeckel umfasst, wobei jedes der Gehäuseteile wannenförmig ausgeformt ist, wodurch das Gehäuseteil und der zugehörige Gehäusedeckel je einen Innenraum einfassen und an jedem Gehäuseteil Ausformungen und zu den Ausformungen komplementäre Ausformungen ausgebildet sind, wobei je zwei Gehäuseteile mittels der Ausformungen des Einen der zwei Gehäuseteile und den komplementären Ausformungen des Anderen der zwei Gehäuseteile miteinander mechanisch und/oder elektrisch, vorzugsweise formschlüssig und/oder kraftschlüssig, lösbar verbunden sind. Von Vorteil dabei ist, dass das Gehäusesystem eine hohe Variabilität aufweist und gleichzeitig einfach und sicher zusammenbaubar ist.

Bei einer vorteilhaften Ausgestaltung weist das Gehäusesystem ein erstes und ein zweites Halteelement auf, wobei das erste Halteelement die Ausformungen aufweist und das zweite Halteelement die komplementären Ausformungen aufweist, wobei das erste Halteelement mit dem Gehäuseteil über dessen komplementäre Ausformungen mechanisch verbunden ist und das zweite Halteelement an dem Gehäuseteil oder einem weiteren Gehäuseteil über dessen Ausformungen mechanisch verbunden ist. Von Vorteil dabei ist, dass die Gehäuseteile einfach und sicher zu einem Gehäusesystem zusammengefügt werden können und trotzdem jedes Gehäuseteil für sich ein abgeschlossenes überprüfbares lagerfähiges Gehäuse beziehungsweise ein Modul bildet. Ein weiterer Vorteil ist, dass Gehäuseteile unterschiedlicher Höhe miteinander verbindbar sind und das Gehäusesystem als Ganzes anbringbar ist, da die Haltemittel entsprechend der größten Höhe angepasst sind.

Bei einer weiteren vorteilhaften Ausgestaltung weisen das erste und das zweite Halteelement je eine Ausnehmung auf, welche durch eine menschliche Hand oder einen Befestigungs-oder Kranhaken durchdringbar ist, und/oder ein Befestigungselement an den Haltelementen ausgeformt ist, mit welchem das erste und zweite Halteelement und mit diesen das Gehäusesystem an einer Hutschiene, einer C-Schiene und/oder einer G-Schiene befestigbar ist. Von Vorteil ist dabei, dass auf einfache und variable Art und Weise Haltemittel am Gehäusesystem vorhanden sind.

Bei einer weiteren vorteilhaften Ausgestaltung sind je zwei Gehäuseteile über eine Vorrichtung zur elektrischen Verbindung, welche vorzugsweise als Steckmodul mit einem ersten und zweiten Steckverbinderteil ausgeführt ist, elektrisch und/oder mechanisch lösbar verbunden. Von Vorteil ist dabei, dass eine innere Verdrahtung zwischen den Gehäuseteilen, wie zum Beispiel eine Einzelverdrahtung durch geeignete Kabeldurchführungen nicht nötig ist.

Bei einer weiteren vorteilhaften Ausgestaltung sind das oder die Gehäuseteile quaderförmig und die Gehäuseteile weisen einen Boden und eine erste Seitenwand und eine der ersten Seitenwand gegenüberliegende zweite Seitenwand sowie eine die erste und zweite Seitenwand verbindende Frontseite und eine entsprechende, der Frontseite gegenüberliegende, Rückseite auf. Von Vorteil ist dabei, dass die Gehäuseteile einfach, variabel und untereinander kompatibel zu einem Gehäusesystem zusammenfügbar sind.

Bei einer weiteren vorteilhaften Ausgestaltung sind als ein erste Art von komplementären Ausformungen an der bodenseitigen Kante der ersten Seitenwand seitlich vorstehende Eingreifelemente ausgebildet und die zugehörige erste Art von Ausformungen sind als an der bodenseitigen Kante der zweite Seitenwand vom Boden her offene Einschnitte ausgebildet. Von Vorteil ist dabei, dass die Gehäuseteile jeweils untereinander kompatibel zu einem Gehäusesystem zusammenfügbar sind.

Bei einer weiteren vorteilhaften Ausgestaltung sind eine zweite Art von Ausformungen im Bereich einer deckelseitige Kante der zweiten Seitenwand als quaderförmige Vorsprünge angeformt und eine zweite Art von komplementäre Ausformungen, welche als zu den quaderförmigen Vorsprüngen komplementäre quaderförmige Eindellungen ausgebildet sind, sind im Bereich einer deckelseitigen Kante der ersten Seitenwand angeordnet. Von Vorteil ist dabei, dass die Gehäuseteile sicher, stabil und variable zusammenfügbar sind.

Bei einer weiteren vorteilhaften Ausgestaltung weisen die quaderförmigen Vorsprünge eine bodenseitige Ausstülpung auf und in einer bodenseitigen Fläche der Eindellungen sind zu den Ausstülpungen korrespondierende Ausnehmungen angeordnet, wobei in einem zusammengebauten Zustand von mehreren Gehäuseteilen die Ausstülpungen in die korrespondierenden Ausnehmungen eingreifen. Von Vorteil ist dabei, dass die Gehäuseteile sicher, einfach und stabil, formschlüssig lösbar zusammenfügbar sind.

Bei einer weiteren vorteilhaften Ausgestaltung sind in der Frontseite durchgehende Ausnehmungen angeordnet, in welchen insbesondere passende Steckverbinderteile angeordnet sind. Von Vorteil ist dabei, dass elektrische Vorrichtungen in den Gehäuseteilen einfach und sicher lösbar mit von außerhalb der Gehäuseteile zugeführten elektrischen Leitungen verbindbar sind.

Bei einer weiteren vorteilhaften Ausgestaltung sind in der Rückseite des oder der Gehäuseteile Öffnungen angeordnet, welche vorzugsweise in an die Seitenwände angrenzenden Endbereichen der Rückseite angeordnet sind. Von Vorteil ist dabei, dass passende Vorrichtungen zur elektrischen Verbindung die jeweils benachbarten Gehäuseteile verbinden können.

Bei einer weiteren vorteilhaften Ausgestaltung weist die Frontseite und/oder die Rückseite in einem bodenseitigen der ersten Seitenwand zugewandten Eckbereich je ein Hakenelement auf, welches über die erste Seitenwand übersteht und in einem bodenseitigen, der zweiten Seitenwand zugeordneten, Eckbereich eine senkrecht auf der Frontseite beziehungsweise der Rückseite abstehendes Zapfenelement aufweist, wobei im zusammengebauten Zustand der mehreren Gehäuseteile das Hakenelement in das jeweilig zugeordnete Zapfenelement des benachbarten Gehäuseteils eingreift. Von Vorteil ist dabei, dass die Gehäuseteile variabel und stabil zu einem Gehäusesystem verbindbar sind.

Bei einer weiteren vorteilhaften Ausgestaltung sind an dem Boden, vorzugsweise als zu den Seitenflächen parallel angeordnete Kühlrippen ausgebildete, Kühlelemente angeformt, wobei die Kühlelemente außerhalb des Innenraums liegen. Von Vorteil ist dabei, dass die Kühlrippen an die jeweiligen Kühlerfordernisse anpassbar sind.

Bei einer weiteren vorteilhaften Ausgestaltung sind die Eingreifelemente und die Einschnitte in freistehenden Endbereichen derjenigen Kühlrippen angeordnet, welche als Verlängerung der ersten und der zweiten Seitenwand ausgeführt sind. Von Vorteil ist dabei, dass die Gehäuseteile einfach und variabel zu einem Gehäusesystem zusammenbaubar sind.

Bei einer weiteren vorteilhaften Ausgestaltung ist ein weiterer Gehäusedeckel wannenförmig ausgeführt und ist mit seiner Öffnung auf einem Passenden der Gehäuseteile angeordnet, wodurch ein weiterer Innenraum gebildet ist. Von Vorteil ist dabei, dass das Gehäusesystem einfach und variabel erweiterbar ist.

Bei einer weiteren vorteilhaften Ausgestaltung sind die Gehäuseteile als Gussteile gefertigt, insbesondere wobei in den Seitenwänden, der Frontseite und/oder der Rückseite passende Steckverbinderteile und/oder Gehäuse für Anschlusssteckverbinderteile angegossen oder eingegossen sind. Von Vorteil ist dabei, dass das Gehäusesystem sicher und einfach mit geeigneten Anschlüssen ausführbar ist.

### Bezugszeichenliste

- 10: Vorrichtung zur elektrischen Verbindung
- 100: Gehäusesystem
- 102: Gehäuseteil
- 104: Gehäusedeckel
- 106: Innenraum
- 108: erste Art von Ausformungen
- 109: zweite Art von Ausformungen
- 110: erste Art von komplementäre Ausformungen
- 111: zweite Art von komplementären Ausformungen
- 112: erstes Halteelement
- 114: zweites Halteelement
- 116: Ausnehmung
- 118: Befestigungselement
- 120: C-Schiene
- 122: Boden
- 123: Abstandszapfen
- 124: erste Seitenwand
- 126: zweite Seitenwand
- 127: Einschubkanäle
- 128: Frontseite
- 129: quaderförmige Ausstülpungen
- 130: Rückseite
- 132: Ausstülpungen
- 134: korrespondierende Ausnehmungen
- 136: durchgehende Ausnehmungen
- 138: passende Steckverbinderteile
- 140: Öffnungen
- 142: Hakenelement
- 144: Zapfenelement
- 146: Kühlrippen
- 148: weiterer Gehäusedeckel
- 149: Verbindungselement
- 150: Gehäuse für Anschlusssteckverbinderteile

Die Erfindung wird nun anhand von Ausführungsbeispielen mit Bezugnahme auf die Zeichnung näher erläutert. Es zeigen rein schematisch:
- Fig. 1:: eine dreidimensionale Explosionsdarstellung eines erfindungsgemäßen Gehäusesystems;
- Fig. 2:: eine dreidimensionale Draufsicht einer weiteren Ausführungsform eines erfindungsgemäßen Gehäusesystems;
- Fig. 3:: eine Seitenansicht des in Figur 2 gezeigten Gehäusesystems; und
- Fig. 4:: eine dreidimensionale Ansicht eines einzelnen Moduls eines erfindungsgemäßen Gehäusesystems.

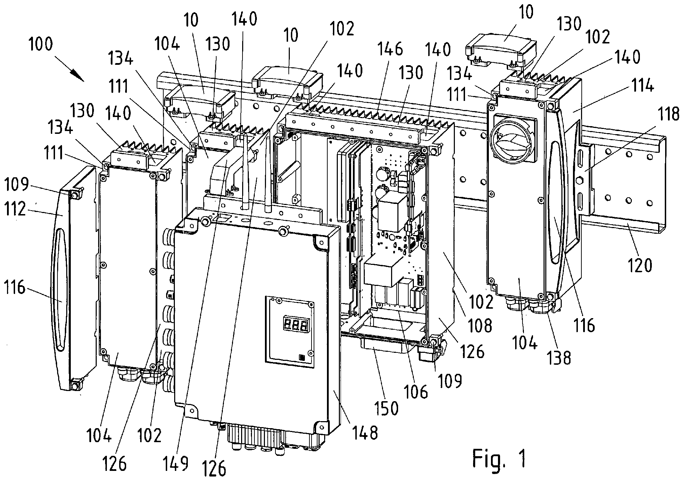

Die Figur 1 zeigt ein erfindungsgemäßes Gehäusesystem 100 in einer dreidimensionalen Explosionsdarstellung. Das Gehäusesystem 100 ist insbesondere als Gehäuse für eine elektrische Vorrichtung, vorzugsweise einen Umrichter zur Ansteuerung eines Elektromotors, geeignet ist und gebraucht wird.

Das Gehäusesystem 100 umfasst mindestens zwei Gehäuseteile 102 mit je einem zugehörigen Gehäusedeckel 104. Ein Gehäuseteil 102 fasst mit dem zugehörigen Gehäusedeckel 104 je einen Innenraum 106 ein. Somit bildet jedes Gehäuseteil 102 mit seinem Gehäusedeckel 104 und eventuellen Anbauteilen ein abgeschlossenes Einzelgehäuse. In diesen Einzelgehäusen sind verschiedene Module der elektrischen Vorrichtung angeordnet. Zum Beispiel gibt es bei einem Gehäusesystem 100 für einen Umrichter ein Gleichrichtermodul, ein Wechselrichtermodul, ein Einschaltmodul und so weiter.

Jedes der Gehäuseteile 102 ist wannenförmig ausgeformt. Das Gehäuseteil 102 ist durch den Gehäusedeckel 104 dicht und/oder berührgeschützt abgeschlossen. Somit kann jedes Einzelgehäuse des Gehäusesystems 100 und somit jedes Modul der elektrischen Vorrichtung einzeln montiert und überprüft werden. Die einzelnen Module sind vorteilhafterweise derart abgeschlossen, dass die Module einzeln abgenommen werden können, das heißt zum Beispiel nach VDE-Normen abgenommen sind. Dies hat den weiteren Vorteil, dass das Gehäusesystem 100 als Ganzes nicht mehr abgenommen beziehungsweise überprüft werden muss. Jedes beliebige Gehäusesystem 100, welches aus den Gehäuseteilen 102 mit zugehörigen Gehäusedeckel 104 aufgebaut ist, weist automatisch die entsprechende Sicherheitsnorm der Einzelgehäuse beziehungsweise Module auf.

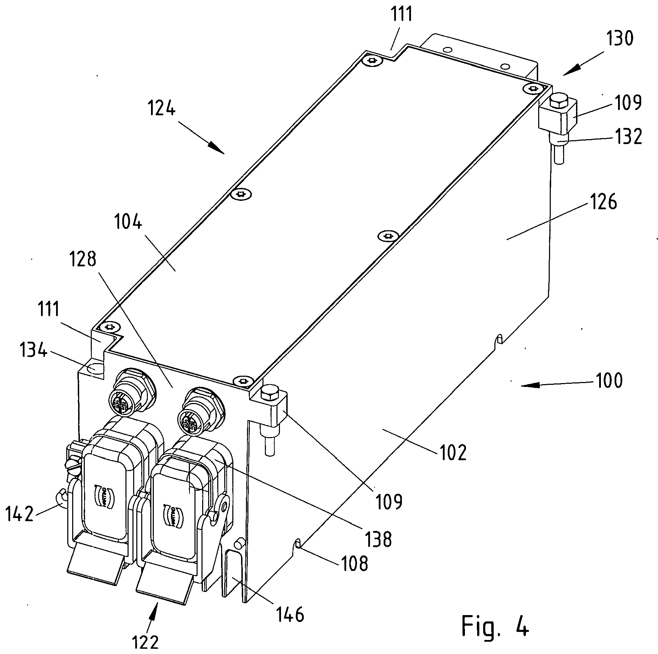

Die in den Figuren 1 bis 4 gezeigten Gehäuseteile 102 weisen einen Boden 122 auf. Mit dem Boden 122 ist eine Gehäusewand einstückig verbunden. Die Gehäusewand besteht aus einer erste Seitenwand 124 und einer der ersten Seitenwand 124 gegenüberliegende zweite Seitenwand 126. Die erste und zweite Seitenwand 124, 126 sind durch eine Frontseite 128 und eine der Frontseite 128 gegenüberliegende Rückseite 130 miteinander verbunden.

An dem Boden 122 sind außerhalb des Innenraums liegende Kühlelemente angeformt. Die Kühlelemente sind vorzugsweise als zu der ersten und zweiten Seitenwand 124, 126 parallel angeordnete Kühlrippen 146 ausgebildete. In einer alternativen Ausführungsform sind auch zum Beispiel Kühlfinger als Kühlelement möglich.

Mit den Kühlrippen 146 sind insbesondere elektronische Bauelemente, wie Dioden oder Transistoren, insbesondere IGBTs oder Thyristoren, über den Boden 122 thermisch verbunden. Dafür sind vorzugsweise zwischen dem elektronischen Bauelement und dem Boden 122 Materialien mit einer Wärmeleitfähigkeit von größer als 4 W/(m K) angeordnet. Der Boden 122 mit den Kühlrippen 146 beziehungsweise das Gehäuseteil 102 ist vorzugsweise aus einem Material mit einer thermischen Leitfähigkeit von größer als 15 W/(m K) insbesondere von größer als 100 W/(m K) gefertigt.

Der Boden 122 weist bei einer bevorzugten Ausführungsform Aufnahmeausformungen auf, um elektronische Bauelement, wie zum Beispiel Kondensatoren oder IGBTs sicher zu platzieren und zu befestigen. Weiter erlauben die Aufnahmeausformungen eine bessere Entwärmung der elektronischen Bauteile. Bei weiteren Ausführungsformen sind an dem Boden senkrecht abstehende Abstandszapfen 123 angeformt. Auf den Abstandzapfen 123 sind vorzugsweise Leiterplatten angebracht. Dazu weisen die Abstandszapfen 123 vorzugsweise Gewindebohrungen auf, so dass die Leiterplatten an den Abstandszapfen 123 angeschraubt sind.

Die erste und zweite Seitenwand 124, 126 sind vorzugsweise über den Boden 122 hinaus als je einer der Kühlrippen 146 verlängert.

Bei einer nicht gezeigten weiteren Ausführungsform der Erfindung ist am Boden eine Halterung für eine Kühler angeformt, so dass ein in der Halterung montierter Kühler eine Luftstrom über die Kühlelemente bewirkt.

Die erste und zweite Seitenwand 124, 126, die Frontseite 128 und die Rückseite 130 bilden zum Deckel hin freistehende Endbereiche. Die freistehenden Endbereiche bilden eine umlaufende Stufe, auf welche der Gehäusedeckel 104 bündig mit den deckelseitigen Enden der Gehäusewand aufgelegt ist. In die Stufe ist eine Dichtung eingelassen vorzugsweise angespritzt oder eingespritzt. Der Gehäusedeckel 104 wird mittels Befestigungselementen gegen die Dichtung gedrückt. Als Befestigungselement sind vorzugsweise Schrauben, insbesondere Senkkopfschrauben, durch passende Schraubenöffnungen im Gehäusedeckel 104 geführt und in entsprechend angeordnet Gewindelöcher in der Gehäusewand eingeschraubt. Eine Höhe des Gehäuseteils 102 ergibt sich aus dem maximalen Abstand zwischen einem freistehenden Ende einer der Kühlelemente und einer umlaufenden Stirnfläche der Gehäusewand, welche bündig mit dem Gehäusedeckel 104 ist.

Damit das Gehäusesystem 100 möglichst einfach und sicher aus den Gehäuseteilen 102 aufgebaut werden kann, sind an jedem Gehäuseteil 102 Ausformungen 108, 109 und zu den Ausformungen 108, 109 komplementäre Ausformungen 110, 111 ausgebildet. Je zwei Gehäuseteile 102 lassen sich mittels der Ausformungen 108, 109 des Einen der zwei Gehäuseteile 102 und den komplementären Ausformungen 110, 111 des Anderen der zwei Gehäuseteile 102 miteinander mechanisch und/oder elektrisch, lösbar verbinden. Die Verbindung zwischen den Gehäuseteilen 102 ist vorzugsweise formschlüssig und/oder kraftschlüssig. Die Gehäuseteile 102 sind vorteilhafterweise so miteinander verbunden, dass die erste Seitenwand 124 des einen Gehäuseteils 102 der zweiten Seitenwand 126 des anderen Gehäuseteils 102 direkt gegenüberliegt und/oder zumindest teilweise berührt.

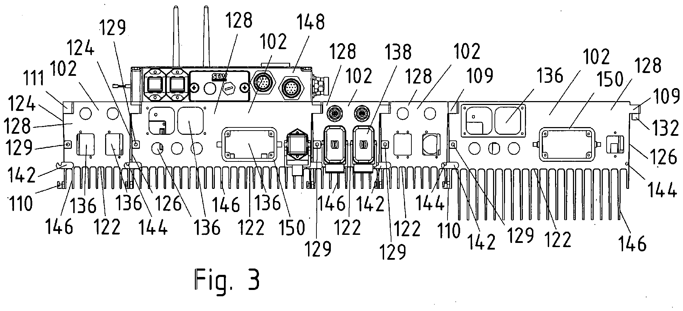

In der in Figur 3 gezeigten Ausführungsform ist eine erste Art von Ausformungen 108 als in Richtung vom Boden 122 zum Gehäusedeckel 104 her offener Einschnitt ausgebildet. Der Einschnitt ist an der bodenseitigen Kante der zweiten Seitenwand 126 beziehungsweise in einem freistehenden Endbereich der als Verlängerung der zweiten Seitenwand 126 ausgebildeten Kühlrippe eingebracht.

Mit der ersten Art von Ausformungen 108 wirkt eine erste Art von komplementären Ausformungen 110 zusammen, um jeweils zwei Gehäuseteil 102 miteinander zu verbinden. Die erste Art von komplementären Ausformungen 110 ist als seitlich vorstehendes Eingreifelement ausgebildet. Das Eingreifelement ist an der bodenseitigen Kante der ersten Seitenwand 124 beziehungsweise in einem freistehenden Endbereich der als Verlängerung der ersten Seitenwand 124 ausgebildeten Kühlrippe angeordnet. Das Eingreifelement steht vorzugsweise senkrecht zur ersten Seitenwand 124 in die vom Gehäuseteil 102 abgewandte Richtung ab.

Die erste Art von komplementären Ausformungen 110 ist vorteilhafterweis als ein eckiges Hakenelement ausgeführt, welches formschlüssig in den Einschnitt in der zweiten Seitenwand 126 des einen Gehäuseteils 102 der jeweils zwei Gehäuseteile 102 eingreift. Dabei hintergreift ein Teilabschnitt des Hakenelementes die Kühlrippe, welche als Verlängerung der zweiten Seitenwand 126 des einen Gehäuseteils 102 ausgeführt ist.

Zur weiteren Verbindung zwischen den jeweils zwei Gehäuseteilen 102 ist eine zweite Art von Ausformungen 109 im Bereich einer deckelseitigen Kante ausgebildet. Die zweite Art von Ausformungen 109 ist vorzugsweise als quaderförmiger Vorsprung ausgebildet, welcher an der zweiten Seitenwand 126 angeformt ist und von dieser senkrecht absteht. Eine Fläche des quaderförmigen Vorsprungs geht insbesondere bündig in die Frontseite 128 beziehungsweise die Rückseite 130 des Gehäuseteils 102 über. Vorzugsweise sind mindestens zwei quaderförmige Vorsprünge an der zweiten Seitenwand 126 angeordnet, wobei ein quaderförmiger Vorsprung in einem Eckbereich zur Frontseite 128 und ein weiterer quaderförmiger Vorsprung in einem Eckbereich zur Rückseite 130 hin an der zweiten Seitenwand 126 angeformt sind.

Die zweite Art von Ausformungen 109 wirken im zusammengebauten Zustand mit einer zweiten Art von komplementären Ausformungen 111 zusammen. Die zweite Art von komplementären Ausformungen 111 ist als zu den quaderförmigen Vorsprüngen komplementäre quaderförmige Eindellungen ausgebildet. Die quaderförmigen Eindellungen sind entsprechen in Bereichen, einer deckelseitigen Kante der zweiten Seitenwand 126 angeordnet. Vorzugsweise sind die Eindellungen in Eckbereichen zur Frontseite 128 beziehungsweise Rückseite 130 hin angeordnet. Die Eindellungen bilden so drei Flächen eines Quaders. Die restlichen Flächen des Quaders sind nicht vorhanden, d.h. die quaderförmigen Eindellungen sind aus drei Richtungen vollflächig zugänglich.

Zur weiteren Fixierung der quaderförmigen Vorsprünge mit den quaderförmigen Eindellungen weisen die quaderförmigen Vorsprünge vorzugsweise eine bodenseitige Ausstülpung 132 auf. Diese Ausstülpung 132 greift im zusammengebauten Zustand der Gehäuseteile 102 in eine korrespondierende Ausnehmungen 134 in einer bodenseitigen Fläche der Eindellungen ein. Somit ist die zweite Art von Ausformungen 109 formschlüssig mit der zweiten Art von komplementären Ausformungen 111 verbunden.

Zur weiteren Sicherung der Verbindung zwischen zwei benachbarten Gehäuseteilen 102 ist ein Sicherungsmittel, insbesondere eine Schraube, durch die quaderförmige Ausstülpung hindurchgeführt und in einem in oder unterhalb der korrespondierenden Ausnehmung 134 angeordneten Befestigungsmittel, insbesondere Gewindeloch, befestigt.

Die mechanischen Verbindungen mittels der Ausformungen 108, 109 und den komplementären Ausformungen 110, 111 insbesondere als Schraubverbindungen erlauben auch einen elektrischen Potentialausgleich zwischen den Gehäuseteilen 102. Dies erlaubt einen einzigen Schutzleiteranschluss für das Gehäusesystem 100. Zum Schutzleiteranschluss weist das Gehäuseteil 102 an der Frontseite 128 eine vorzugsweise quaderförmige Ausstülpung auf, welche Senkrecht von der Frontseite 128 absteht. Von einer freistehenden Stirnfläche aus ist in die quaderförmige Ausstülpung eine Gewindebohrung eingearbeitet.

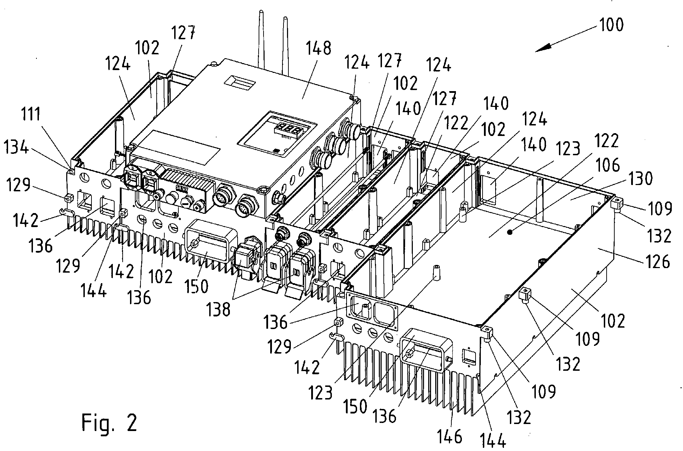

Bei größeren Ausführungsformen der Gehäuseteile 102, d.h. mit längeren ersten und zweiten Seitenwänden 124, 126, wie zum Beispiel auch in der Figur 2 ganz rechts zu sehen, sind zusätzliche Ausformungen 108, 109 und zusätzliche komplementäre Ausformungen 110, 111 angebracht. Dies erlaubt vor allem die sichere und stabile Zusammenbaubarkeit, d.h. Kompatibilität, dieser größeren Ausführungsform der Gehäuseteile 102 mit kleineren Ausführungsformen der Gehäuseteile 102.

In der Frontseite 128 sind durchgehende Ausnehmungen 136 angeordnet oder eingebracht. Die durchgehenden Ausnehmungen 136 sind entweder bei einem Gießprozess zur Herstellung des Gehäuseteils 102 mit entsprechenden Formmitteln direkt gefertigt oder nachträglich eingebracht, insbesondere gebohrt oder gefräst. Die durchgehenden Ausnehmung 136 dienen unter anderem als Kabeldurchführung in dem passende Steckverbinderteile in den durchgehenden Ausnehmungen 136 angeordnet insbesondere angeschraubt sind. Vorteilhafterweise ist zumindest bei einem der Gehäuseteile 102 ein Gehäuse 150 für ein Anschlusssteckverbinderteil um eine der durchgehenden Ausnehmung 136 einstückig angeformt, insbesondere angegossen. Die passenden Steckverbinderteile verschließen die durchgehenden Ausnehmungen 136 vorzugsweise abdichtend, insbesondere gemäß einer bekannten Schutzklasse wie zum Beispiel IP65 oder IP54.

In der Rückseite 130 des oder der Gehäuseteile 102 ist eine Öffnungen 140 angeordnet. Vorzugsweise sind je zwei der Öffnungen 140 in den Rückseiten 130 der Gehäuseteile 102 in an die erste und zweite Seitenwand 124, 126 angrenzenden Endbereichen angeordnet. Die Öffnungen 140 weisen insbesondere identische Ausmaße auf und haben zur jeweils nächstliegenden ersten oder zweiten Seitenwand 124, 126 denselben Abstand.

Um die einzelnen in den Innenräumen 106 der Gehäuseteilen 102 angeordneten Module der elektrischen Vorrichtung funktional, das heißt insbesondere elektrisch miteinander zu verbinden, sind je zwei Gehäuseteile 102 über eine Vorrichtung 10 zur elektrischen Verbindung elektrisch und/oder mechanisch lösbar verbunden. Die Vorrichtung 10 zur elektrischen Verbindung ist vorzugsweise als Steckmodul mit einem ersten und zweiten Steckverbinderteil ausgeführt.

Zwei zu den Öffnungen 140 passend ausgeführt Einführhilfen der Vorrichtung 10 zur elektrischen Verbindung greifen in je eine Öffnung 140 zweier benachbarter Gehäuseteile 102 ein. Im Innenraum 106 des jeweiligen Gehäuseteils 102 ist je ein Gegensteckverbinderteil angeordnet in dem je eines der ersten und zweiten Steckverbinderteile der Vorrichtung 10 zur elektrischen Verbindung eingesteckt ist.

Dadurch werden je zwei der einzelnen in sich abgeschlossenen, jeweils eine elektrische Funktionalität aufweisenden Gehäuseteile 102 miteinander elektrisch Verbunden. Vorzugsweise sind die Vorrichtungen 10 zur elektrischen Verbindung die Öffnungen 140 Abdichtend angebracht, insbesondere angeschraubt. Durch diese dichtende, feste Verbindung sind die jeweils benachbarten Gehäuseteile 102 auch mechanisch miteinander verbunden.

Vorzugsweise sind die Gegensteckverbinderteile an eine Leiterplatte angeordnet. Die Leiterplatte ist vorzugsweise als Rückplatte, beziehungsweise in der Fachsprache als Backplane bekannt, ausgeführt. Dadurch lassen sich verschiedene elektrische Verbindungen auf einfache und sichere Art und Weise auch bei mehreren Gehäuseteilen 102 leicht zusammenbaubar durchschleifen. Somit sind vorteilhafterweise alle elektrischen Signale einer Rückplatte eines bestimmten Gehäuseteils 102 in allen Gehäuseteilen 102 verfügbar. Die Rückplatten sind in sich im Innenraum 106 gegenüberliegenden Haltevorrichtungen angeordnet. Die Haltevorrichtungen sind vorzugsweise als Einschubkanäle 127 ausgeführt, so dass die Rückplatten einfach von der offenen Seite der Gehäuseteile 102 in den Innenraum 106 eingeschoben werden und vom Gehäusedeckel 104 fixiert sind.

Als zusätzliche mechanische Verbindungselemente weisen bei den in den Figuren 1 bis 4 gezeigten Gehäuseteile 102 die jeweiligen Frontseiten 128 in einem bodenseitigen der ersten Seitenwand 124 zugewandten Eckbereich je ein Hakenelement 142 auf. Das Hakenelement 142 steht über die jeweilige erste Seitenwand 124 über. Mit dem Hakenelement 142 wirkt ein Zapfenelement 144 zusammen. Das Zapfenelement 144 ist in einem bodenseitigen der zweiten Seitenwand 126 zugeordneten Eckbereich senkrecht auf der Frontseite 128 angeordnet. Im zusammengebauten Zustand der mehreren Gehäuseteile 102 greift das Hakenelement 142 in das jeweilig zugeordnete Zapfenelement 144 des benachbarten Gehäuseteils 102 ein.

Das Gehäusesystem 100 ist an einen Vorrichtung oder Maschine direkt befestigbar oder an eine allgemeine bekannte Haltevorrichtung, wie zum Beispiel eine Hutschiene, eine G-Schiene oder eine in Figur 1 gezeigte C-Schiene 120 befestigbar.

Zu diesem Zwecke weist das Gehäusesystem 100 ein erstes und ein zweites Halteelement 112, 114 auf. An den Haltelementen 112, 114 ist ein Befestigungselement 118 ausgeformt, mit welchem das erste und zweite Halteelement 112, 114 in die entsprechende Haltevorrichtung eingreift. Das Befestigungselement 118 ist komplementär zur Haltevorrichtung ausgeformt.

Das erste Halteelement 112 weist die Ausformungen 108, 109 auf und das zweite Halteelement 114 die komplementären Ausformungen 110, 111. Somit ist das erste Haltemittel 112 mit dem Gehäuseteil 102 über dessen komplementäre Ausformungen 110, 111 mechanisch verbunden. Das zweite Haltemittel 114 ist an dem Gehäuseteil 102 oder einem weiteren Gehäuseteil 102 über dessen Ausformungen 108, 109 mechanisch verbunden.

Da das erste und zweite Haltelement 112, 114 nur an einer Seite die Ausformungen 108, 109 oder die komplementären Ausformungen 110, 111 aufweisen, sind die Halteelemente auch als Abschlusselemente ausgeführt an die keine weiteren Gehäuseteile 102 anfügbar sind.

Vorzugsweise sind die insbesondere quaderförmigen Gehäuseteile 102 entlang einer Achse aufgereiht miteinander verbunden. Das erste und zweite Halteelement 112, 114 bilden somit entlang dieser Achse Abschlusselemente des Gehäusesystems 100.

Zur besseren Handhabbarkeit des Gehäusesystems 100 weist das erste und zweite Halteelement 112, 114 je eine Ausnehmung 116 auf. Die Ausnehmung 116 ist in einer deckelseitigen Auskragung in Richtung weg vom Gehäuseteil 102 des Halteelementes 112, 114 angeordnet. Vorzugsweise ist die Ausnehmung 116 ellipsenförmig. Die Ausmaße der Ausnehmung 116 ist vorteilhafterweise so ausgeführt, dass zumindest die Finger einer menschliche Hand oder ein Befestigungs- oder Kranhaken die Ausnehmung durchdringen kann. So ist das Gehäusesystem 100 mittels zwei Händen von einer Person einfach und sicher bewegbar.

Ein weiterer Gehäusedeckel 148 ist wannenförmig ausgeführt und mit seiner Öffnung auf einem Passenden der Gehäuseteile 102 angeordnet ist, wodurch ein weiterer Innenraum gebildet ist. Der weitere Gehäusedeckel 148 schließt entweder zusammen mit dem Passenden der Gehäuseteile 102, auf welchem der weitere Gehäusedeckel 148 befestigt ist, einen gemeinsamen Innenraum ein oder der Gehäusedeckel 104 des Passenden der Gehäuseteile 102 trennt den Innenraum 106 des Passenden der Gehäuseteils 102 von einem weiteren Innenraum des weiteren Gehäusedeckel 148 ab.

In letzterem Fall ist an der Rückseite 130 des Passenden der Gehäuseteile 102 und der entsprechenden Rückseite des weiteren Gehäusedeckels 148 ein Verbindungselement 149 zur elektrischen Verbindung angebracht, welches in ähnlicher Art und Weise wie die Vorrichtung 10 zur elektrischen Verbindung die elektrischen und elektronischen Komponenten im weiteren Gehäusedeckel 148 mit den elektrischen und /oder elektronischen Komponenten in dem Passenden der Gehäuseteile 102 elektrisch verbindet.

Vorzugsweise ist diese elektrische Verbindung ebenfalls über die Backplane bzw. Rückplatte im Passenden der Gehäuseteile 102 realisiert, so dass elektrische Signale der Komponenten im weiteren Gehäusedeckel 148 auf einfache Art und Weise in jedem der Gehäuseteile 102 zur Verfügung stehen.

In einer nichtgezeigten Ausführungsform ist diese elektrische Verbindung durch eine durchgehende Aussparung im Gehäusedeckel 104, vorzugsweise als Steckverbindung ausgebildet, so dass der weitere Gehäusedeckel 148 mittels der Steckverbindung auf das Passende der Gehäuseteile 102 aufgesteckt wird und anschließend mit weiteren Befestigungsmitteln am Passenden der Gehäuseteile 102 befestigt.

Im weiteren Gehäusedeckel 148 ist vorzugsweise die Ansteuerungselektronik, wie eine speicherprogrammierbare Steuerung oder ein eventuell notwendige Sicherheitssteuerung zu sicheren Überwachung der Ansteuerung angeordnet. Dadurch sind die empfindlicheren elektronischen Bauteile von eventuell größeren Wärmemengen erzeugender Bauteile des in den Gehäuseteilen 102 untergebrachten Umrichterelektronik besser getrennt.

Bei einer bevorzugten Ausführungsform ist in dem weiteren Gehäusedeckel 148 eine Kommunikationselektronik angeordnet, welche mit am weiteren Gehäusedeckel 148 angebracht Antennen verbunden ist. Der weitere Gehäusedeckel weist bevorzugterweise eine von außerhalb sichtbare Anzeigevorrichtung auf. Die Anzeigevorrichtung ist vorzugsweis in einer Durchgangsöffnung des weiteren Gehäusedeckels 148 angebracht.

Alternativ lassen sich die Ansteuerungselektronik und die Sicherungselektronik in einem gemeinsamen oder in je einem Gehäuseteil 102 mit passendem Gehäusedeckel 104 unterbringen. In dieser weiteren Ausführungsform ist das Gehäusesystem nur aus Gehäuseteilen 102 mit entsprechendem Gehäusedeckel 104 und den Halteelementen 112, 114 sowie den entsprechenden Vorrichtungen zur elektrischen Verbindung aufgebaut.

Der weitere Gehäusedeckel 148 oder das entsprechende Gehäuseteil 102 weist vorzugsweise Anschlussmöglichkeiten für Busleitungen, eine Anzeigefeld, welches von außerhalb des Gehäusesystem einsehbar ist, sowie nötige Kabeldurchführungen vorzugsweise als Steckverbinderteil, insbesondere für eine Busleitung auf.

Nicht benutzte Öffnungen 140 oder durchgehende Ausnehmungen 136 sind vorzugsweise durch entsprechende Dichtelemente verschließbar oder alternativ nur benutzte Öffnungen 140 und durchgehende Ausnehmungen 136 werden mittels umlaufender Sollbruchstellen bei Bedarf aus der Gehäusewand des Gehäuseteils 102 oder dem Gehäusedeckel 104 herausgebrochen.

Die Gehäuseteile 102 sind vorteilhafterweise als Gussteile gefertigt. Bei einem besonders bevorzugten Ausführungsform des Herstellungsverfahrens werden in den ersten und zweiten Seitenwänden 124, 126, der Frontseite 128, und/oder der Rückseite 130 passende Steckverbinderteile 138 und/oder Gehäuse 150 für Anschlusssteckverbinderteile angegossen oder eingegossen.

Das erfindungsgemäße Gehäusesystem 100 ist vorzugsweise für einen Umrichter vorgesehen. Dazu lassen sich die einzelnen Modul eines Umrichters, wie Gleichrichter, Wechselrichter, Zwischenkreis, Bremswiderstand, Rückspeisemodul und so weiter in je einem Gehäuseteil 102 mit Gehäusedeckel 104 ausführen.

Die Gehäuseteile 102 mit Gehäusedeckel 104 bilden jeweils gekapselte Kühlkörpermodule, welche einzeln abgeschlossen, geprüft und lagerfähig sind. Dadurch können die einzelnen Module nach den gängigen Richtlinien geprüft und von den zuständigen Behörden abgenommen werden. Ein Gehäusesystem 100, welches aus einzeln geprüften Modulen bzw. Gehäuseteilen 102 aufgebaut ist, ist dann als Ganzes schon geprüft. Somit erreicht man eine Hohe Varianz an unterschiedliche, auf spezielle Bedürfnisse abgestimmte, elektrische Vorrichtungen bei vereinfachter Zertifizierung.

Die Kühlkörpermodule sind in hoher Schutzart, wie zum Beispiel IP 65 ausführbar. Somit ist dann auch das Gehäusesystem 100 in hoher Schutzart fertigbar.

Durch die Kombinationsfähigkeit der einzelnen Module bzw. Gehäuseteilen 102 sind auf einfache Art und Weise beliebige Umrichter bzw. Gehäusesysteme 100 fertigbar.

Es ist auch möglich das Gehäusesystem mit weiteren Anbaugehäusen entsprechend zu ergänzen oder den Innenraum der Gehäuseteile 102 durch weitere Gehäuseelemente wie Steckverbinderteile oder Anbaugehäuse abzuschließen.

## Patentansprüche

1. Gehäusesystem,
welches mindestens zwei Gehäuseteile (102) mit je einem zugehörigen Gehäusedeckel (104) umfasst,
wobei jedes der Gehäuseteile (102) wannenförmig ausgeformt ist, wodurch das Gehäuseteil (102) und der zugehörige Gehäusedeckel (104) je einen Innenraum einfassen, und an jedem Gehäuseteil Ausformungen (108) und zu den Ausformungen komplementäre Ausformungen (110) ausgebildet sind,
wobei je zwei Gehäuseteile mittels der Ausformungen (108) des einen der zwei Gehäuseteile und den komplementären Ausformungen (110) des anderen der zwei Gehäuseteile miteinander mechanisch und/oder elektrisch, vorzugsweise formschlüssig und/oder kraftschlüssig, lösbar verbunden sind,
wobei je zwei Gehäuseteile (102) über eine Vorrichtung (10) zur elektrischen Verbindung, welche als Steckmodul mit einem ersten und zweiten Steckverbinderteil ausgeführt ist, elektrisch und/oder mechanisch lösbar verbunden sind,
wobei das oder die Gehäuseteile (102) quaderförmig sind und die Gehäuseteile einen Boden (122) und eine erste Seitenwand (124) und eine der ersten Seitenwand gegenüberliegende zweite Seitenwand (126) sowie eine die erste und zweite Seitenwand verbindende Frontseite (128) und eine entsprechende der Frontseite gegenüberliegende Rückseite (130) aufweisen,
wobei als eine erste Art von komplementären Ausformungen (110) an der bodenseitigen Kante der ersten Seitenwand (124) seitlich vorstehende Eingreifelemente ausgebildet sind und die zugehörige erste Art von Ausformungen (108) als an der bodenseitigen Kante der zweiten Seitenwand (126) vom Boden her offene Einschnitte ausgebildet sind, wobei die Frontseite und die Rückseite in einem bodenseitigen der ersten Seitenwand zugewandten Eckbereich je ein Hakenelement (142) aufweisen, welches über die erste Seitenwand (124) übersteht und in einem bodenseitigen der zweiten Seitenwand (126) zugeordneten Eckbereich ein senkrecht auf der Frontseite beziehungsweise der Rückseite abstehendes Zapfenelement (144) aufweisen, wobei im zusammengebauten Zustand der mehreren Gehäuseteile das Hakenelement (142) in das jeweilig zugeordnete Zapfenelement (144) des benachbarten Gehäuseteils eingreift, wobei an dem Boden Kühlelemente (146) angeformt sind, wobei die Kühlelemente außerhalb des Innenraums liegen, wobei die Kühlelemente als zu den Seitenwänden (124,126) parallel angeordnete Kühlrippen (146) ausgebildet sind, wobei die Eingreifelemente (110) und die Einschnitte (108) in freistehenden Endbereichen derjenigen Kühlrippen (146) angeordnet sind, welche als Verlängerung der ersten und zweiten Seitenwand ausgeführt sind, so dass die erste und zweite Seitenwand (124,126) über den Boden hinaus als je eine der Kühlrippen (146) verlängert ist.

2. Gehäusesystem nach Anspruch 1,
wobei das Gehäusesystem ein erstes und ein zweites Halteelement (112,114) aufweist, wobei das erste Halteelement die Ausformungen (108) aufweist und das zweite Halteelement die komplementären Ausformungen (110) aufweist, wobei das erste Halteelement mit dem Gehäuseteil über dessen komplementäre Ausformungen mechanisch verbunden ist und das zweite Halteelement an dem Gehäuseteil oder einem weiteren Gehäuseteil über dessen Ausformungen mechanisch verbunden ist.

3. Gehäusesystem nach Anspruch 2,
**dadurch gekennzeichnet, dass**
das erste und zweite Halteelement je eine Ausnehmung aufweisen, welche durch eine menschliche Hand oder einen Befestigungs- oder Kranhaken durchdringbar ist, und/oder ein Befestigungselement an den Haltelementen ausgeformt ist mit welchem das erste und zweite Halteelement und mit diesen das Gehäusesystem an einer Hutschiene, einer C-Schiene und/oder einer G-Schiene befestigbar ist.

4. Gehäusesystem nach Anspruch 1,
wobei eine zweite Art von Ausformungen (109) im Bereich einer deckelseitige Kante der zweiten Seitenwand (126) als quaderförmige Vorsprünge angeformt sind und eine zweite Art von komplementäre Ausformungen (111), welche als zu den quaderförmigen Vorsprüngen komplementäre quaderförmige Eindellungen ausgebildet sind, im Bereich einer deckelseitigen Kante der ersten Seitenwand (124) angeordnet sind.

5. Gehäusesystem nach Anspruch 4,
**dadurch gekennzeichnet, dass**
die quaderförmigen Vorsprünge eine bodenseitige Ausstülpung aufweisen und in einer bodenseitigen Fläche der Eindellungen zu den Ausstülpungen korrespondierende Ausnehmungen angeordnet sind, wobei in einem zusammengebauten Zustand von mehreren Gehäuseteilen die Ausstülpungen in die korrespondierenden Ausnehmungen eingreifen.

6. Gehäusesystem nach mindestens einem der vorangegangenen Ansprüche,
**dadurch gekennzeichnet, dass**
in der Frontseite durchgehende Ausnehmungen angeordnet sind, in welchen insbesondere passende Steckverbinderteile angeordnet sind.

7. Gehäusesystem nach einem der vorangegangenen Ansprüche,
**dadurch gekennzeichnet, dass**
in der Rückseite des oder der Gehäuseteile Öffnungen angeordnet sind, welche vorzugsweise in an die Seitenwänden angrenzenden Endbereichen der Rückseite angeordnet sind.

8. Gehäusesystem nach einem der vorangegangenen Ansprüche,
**dadurch gekennzeichnet, dass**
ein weiterer Gehäusedeckel wannenförmig ausgeführt ist und mit seiner Öffnung auf einem Gehäuseteil angeordnet ist, wodurch ein weiterer Innenraum gebildet ist.

9. Gehäusesystem nach einem der vorangegangenen Ansprüche,
**dadurch gekennzeichnet, dass**
die Gehäuseteile als Gussteile gefertigt sind,
insbesondere wobei in den Seitenwänden, der Frontseite und/oder der Rückseite passende Steckverbinderteile und/oder Gehäuse für Anschlusssteckverbinderteile angegossen oder eingegossen sind.

## Claims

1. Housing system,
which comprises at least two housing parts (102), each having an associated housing cover (104),
wherein each of the housing parts (102) is of trough-shaped form, whereby the housing part (102) and the associated housing cover (104) each enclose an inner space, and formations (108) and formations (110) complementary to the formations are formed on each housing part,
wherein each two housing parts are detachably connected to one another mechanically and/or electrically, preferably in a form-locking and/or force-locking manner, by means of the formations (108) of one of the two housing parts and the complementary formations (110) of the other of the two housing parts,
wherein each two housing parts (102) are detachably connected electrically and/or mechanically via a device (10) for electrical connection which is implemented as a plug-in module having a first and second plug-in connector part,
wherein the housing part or housing parts (102) are of cuboid shape and the housing parts have a bottom (122) and a first side wall (124) and a second side wall (126) opposite the first side wall, and also a front side (128) connecting the first and second side wall and a corresponding rear side (130) opposite the front side,
wherein as a first type of complementary formations (110) laterally projecting engagement elements are formed on the bottom edge of the first side wall (124) and the associated first type of formations (108) are formed as notches open from the bottom on the bottom edge of the second side wall (126), wherein the front side and the rear side each have a hook element (142) in a bottom corner region facing the first side wall, which hook element protrudes beyond the first side wall (124), and in a bottom corner region associated with the second side wall (126) a pin element (144) projecting vertically on the front side and the rear side, respectively, wherein in the assembled state of the plurality of housing parts the hook element (142) engages in the respectively associated pin element (144) of the adjacent housing part, wherein cooling elements (146) are integrally formed on the bottom, wherein the cooling elements lie outside the inner space, wherein the cooling elements are formed as cooling ribs (146) arranged parallel to the side walls (124, 126), wherein the engagement elements (110) and the notches (108) are arranged in freestanding end regions of the respective cooling ribs (146) which are implemented as an extension of the first and second side wall, so that the first and second side wall (124,126) is extended beyond the bottom each as one of the cooling ribs (146).

2. Housing system according to Claim 1,
wherein the housing system has a first and a second holding element (112,114), wherein the first holding element has the formations (108) and the second holding element has the complementary formations (110), wherein the first holding element is mechanically connected to the housing part via its complementary formations and the second holding element is mechanically connected to the housing part or a further housing part via its formations.

3. Housing system according to Claim 2,
**characterised in that**
the first and second holding element each have a recess which can be penetrated by a human hand or a fastening hook or crane hook, and/or a fastening element is formed on the holding elements, with which the first and second holding element and with these the housing system can be fastened to a top hat rail, a C-rail and/or a G-rail.

4. Housing system according to Claim 1,
wherein a second type of formations (109) are formed in the region of a top edge of the second side wall (126) as cuboid-shaped projections and a second type of complementary formations (111), which are formed as cuboid-shaped indentations complementary to the cuboid-shaped projections, are arranged in the region of a top edge of the first side wall (124).

5. Housing system according to Claim 4,
**characterised in that**
the cuboid-shaped projections have a bottom protuberance and in a bottom surface of the indentations recesses corresponding to the protuberances are arranged, wherein in an assembled state of a plurality of housing parts the protuberances engage in the corresponding recesses.

6. Housing system according to at least one of the preceding claims,
**characterised in that**
through-openings are arranged in the front side, in which through-openings in particular mating plug-connector parts are arranged.

7. Housing system according to at least one of the preceding claims,
**characterised in that**
openings are arranged in the rear side of the housing part or housing parts, which openings are preferably arranged in end regions of the rear side adjacent to the side walls.

8. Housing system according to at least one of the preceding claims,
**characterised in that**
a further housing cover is of trough-shaped configuration and is arranged with its opening on a housing part, whereby a further inner space is formed.

9. Housing system according to at least one of the preceding claims,
**characterised in that**
the housing parts are produced as castings,
in particular wherein in the side walls, the front side and/or the rear side, mating plug-connector parts and/or housings for connecting plug-connector parts are cast on or cast in.

## Revendications

1. Système de boîtier comprenant
au moins deux parties (102) dont chacune est munie d'un couvercle (104) associé, chacune desdites parties (102) du boîtier étant réalisée en forme d'auge, de sorte que ladite partie (102) du boîtier et ledit couvercle associé (104) dudit boîtier circonscrivent un espace interne respectif, des profilages (108), et des profilages (110) complémentaires de ces derniers, étant ménagés sur chaque partie dudit boîtier,
deux parties respectives dudit boîtier étant reliées l'une à l'autre mécaniquement et/ou électriquement de manière libérable, de préférence par complémentarité de formes et/ou par engagement positif, au moyen des profilages (108) de l'une desdites deux parties du boîtier, et des profilages complémentaires (110) de l'autre desdites deux parties du boîtier, deux parties respectives (102) du boîtier étant reliées électriquement et/ou mécaniquement de manière libérable, par l'intermédiaire d'un dispositif (10) dévolu au raccordement électrique et réalisé sous la forme d'un module enfichable, comprenant des première et seconde pièces de connexion par enfichage,
la ou les partie(s) (102) du boîtier revêtant la forme d'un quadrilatère, et lesdites parties dudit boîtier comprenant un fond (122), une première paroi latérale (124) et une seconde paroi latérale (126) située en vis-à-vis de ladite première paroi latérale, ainsi qu'une face avant (128) reliant lesdites première et seconde parois latérales, et une face arrière (130) correspondante, située en vis-à-vis de ladite face avant,
sachant que des éléments de venue en prise faisant saillie latéralement sont façonnés, en tant que premier type de profilages complémentaires (110), sur l'arête de la première paroi latérale (124) qui est située côté fond, et que le premier type de profilages (108) associé est réalisé sous la forme d'encoches ouvertes, à partir du fond, sur l'arête de la seconde paroi latérale (126) qui est située côté fond, la face avant et la face arrière étant dotées, dans une zone d'angle située côté fond et tournée vers la première paroi latérale, d'un élément respectif d'accrochage (142) dépassant au-delà de ladite première paroi latérale (124) et, dans une zone d'angle située côté fond et associée à ladite seconde paroi latérale (126), d'un téton (144) faisant respectivement saillie, dans le sens vertical, sur ladite face avant ou ladite face arrière,
sachant qu'à l'état assemblé des multiples parties du boîtier, ledit élément d'accrochage (142) pénètre dans le téton (144) de la partie de boîtier voisine, respectivement associé, sachant que des éléments de refroidissement (146) font corps avec le fond, lesquels éléments de refroidissement sont disposés à l'extérieur de l'espace interne, lesdits éléments de refroidissement étant réalisés sous la forme d'ailettes de refroidissement (146) agencées parallèlement aux paroi latérales (124, 126), les éléments (110) de venue en prise et les encoches (108) se trouvant dans des régions extrêmes libres des ailettes de refroidissement (146) considérées, qui sont réalisées en tant que prolongement des première et seconde parois latérales, si bien que lesdites première et seconde parois latérales (124, 126) sont prolongées au-delà du fond en matérialisant l'une respective desdites ailettes de refroidissement (146).

2. Système de boîtier selon la revendication 1,
ledit système de boîtier comportant des premier et second éléments de maintien (112, 114), le premier élément de maintien étant muni des profilages (108), et le second élément de maintien étant pourvu des profilages (110) complémentaires, ledit premier élément de maintien étant relié mécaniquement à la partie de boîtier par l'intermédiaire de ses profilages complémentaires et ledit second élément de maintien étant relié mécaniquement à la partie de boîtier, ou à une autre partie de boîtier, par l'intermédiaire de ses profilages complémentaires.

3. Système de boîtier selon la revendication 2,
**caractérisé par le fait que**
les premier et second éléments de maintien sont dotés d'un évidement respectif pouvant être traversé par une main humaine, ou par un crochet de fixation ou de grutage ; et/ou un élément de fixation, façonné sur lesdits éléments de maintien, permet de fixer lesdits premier et second éléments de maintien et de fixer ledit système de boîtier, avec ces derniers, à un profilé chapeau, à un profilé en C et/ou à un profilé en G.

4. Système de boîtier selon la revendication 1,
dans lequel un second type de profilages (109) se présente comme des saillies rectangulaires solidaires, dans la région d'une arête de la seconde paroi latérale (126) qui est située côté couvercle, et un second type de profilages (111) complémentaires, réalisés en tant que renfoncements rectangulaires complémentaires desdites saillies rectangulaires, se trouve dans la région d'une arête de la première paroi latérale (124) qui est située côté couvercle.

5. Système de boîtier selon la revendication 4,
**caractérisé par le fait que**
les saillies rectangulaires présentent une protubérance inférieure, et des évidements concordant avec les protubérances sont pratiqués dans une surface inférieure des renfoncements, lesdites protubérances pénétrant des lesdits évidements concordants lorsque plusieurs parties du boîtier sont à l'état assemblé.

6. Système de boîtier selon au moins l'une des revendications précédentes,
**caractérisé par le fait que**
des évidements traversants, dans lesquels sont notamment logées des pièces adaptées de connexion par enfichage, sont pratiqués dans la face avant.

7. Système de boîtier selon l'une des revendications précédentes,
**caractérisé par le fait que**
des orifices, pratiqués dans la face arrière de la ou des partie(s) du boîtier, sont de préférence situés dans des régions extrêmes de ladite face arrière qui sont limitrophes des parois latérales.

8. Système de boîtier selon l'une des revendications précédentes,
**caractérisé par le fait**
**qu'**un couvercle supplémentaire du boîtier est réalisé en forme d'auge et coiffe une partie dudit boîtier, par son ouverture, ce qui donne naissance à un espace interne supplémentaire.

9. Système de boîtier selon l'une des revendications précédentes,
**caractérisé par le fait que**
les parties du boîtier sont produites en tant que pièces coulées,
sachant notamment que des pièces adaptées de connexion par enfichage, et/ou des boîtiers dédiés à des pièces enfichables de raccordement, sont rapporté(e)s ou intégré(e)s par coulée sur, ou dans les parois latérales, la face avant et/ou la face arrière.
